# EUROPEAN PATENT APPLICATION

(11) **EP 3 016 236 A1**
(43) Date of publication of application: **04.05.2016**
(21) Application number: 15190409.1
(22) Date of filing: 19.10.2015
(51) Int. Cl.: H02J 7/00, H02M 1/12, H02M 1/44

(54) **POWER SUPPLY CIRCUIT AND ELECTRONIC EQUIPMENT**

(30) Priority: 31.10.2014 CN 201410601593
(71) Applicant: Xiaomi Inc., Beijing 100085 (CN)
(72) Inventor: SUN, Wei, 100085 Beijing (CN); DI, Hao, 100085 Beijing (CN); SHI, Xinming, 100085 Beijing (CN)
(74) Representative: Sackin, Robert

(57) **Abstract**

The present disclosure relates to a power supply circuit and an electronic equipment, pertaining to the field of electronic circuit. The power supply circuit includes: a battery (120, 220), a power management chip (140, 240) and a radio frequency (RF) chip (160, 260); an output terminal of the battery is connected to at least one input terminal of the power management chip, while the at least one input terminal of the power management chip is individually grounded via a corresponding filter capacitor (C1), respectively; and the output terminal of the battery is also connected to an input terminal of the RF chip via a switching power supply circuit (180, 280). In the present disclosure, a switching power supply circuit is provided between the output terminal of the battery and the input terminal of the RF chip, thus the noise produced by the ceramic capacitor, which may still generate vibration although, during its vibration is inaudible for human.

## Description

### TECHNICAL FIELD

The present disclosure relates to the field of electronic circuit, and more particularly, to a power supply circuit and an electronic equipment.

### BACKGROUND

In a mobile phone, an output terminal of a battery generally is connected to an RF (Radio Frequency) chip and a power management chip respectively. Namely, the battery not only supplies power to the RF chip, but also supplies power to other electronic components on a mainboard of the mobile phone by means of the power management chip.

Generally a grounded filter capacitor is provided between the output terminal of the battery and the power management chip. MLCC (Multi Layer Ceramic Capacitors) is typically used as a package type of the filter capacitor.

Due to piezoelectric effect, the ceramic capacitor may vibrate and give out audible noise when the RF chip sends out signal at a frequency of 216.8HZ required for GSM (Global System for Mobile Communication) network.

### SUMMARY

The embodiments of the present disclosure provide a power supply circuit and an electronic equipment. The technical solution is described as below.

According to the first aspect of the embodiments of the present disclosure, a power supply circuit is provided, comprising: a battery, a power management chip and an RF chip;
an output terminal of the battery is connected to at least one input terminal of the power management chip, while the at least one input terminal is individually grounded via a corresponding filter capacitor; and
the output terminal of the battery is further connected to an input terminal of the RF chip via a switching power supply circuit.

In an embodiment, the switching frequency of the switching power supply circuit is greater than a limiting frequency of human audible sound.

In an embodiment, the switching power supply circuit is a DC BOOST switching power supply circuit.

In an embodiment, the switching power supply circuit is a DC BUCK switching power supply circuit.

In an embodiment, the input terminal of the RF chip is grounded via an RF filter capacitor.

In an embodiment, the RF filter capacitor is a tantalum capacitor.

In an embodiment, the filter capacitor is a ceramic capacitor.

According to the second aspect of the embodiments of the present disclosure, an electronic equipment is provided, comprising the power supply circuit according to the first aspect.

The technical solution according to the embodiments of the present disclosure may have the following beneficial effects.

A switching power supply circuit is provided between the output terminal of the battery and the input terminal of the RF chip, solving the problem that a ceramic capacitor may vibrate and give out audible noise when the RF chip sends out signal at a frequency of 216.8HZ required for the communication network, and reaching the effect that the noise produced by the ceramic capacitor, which may still generate vibration although, during its vibration is inaudible for human as the switching frequency of the switching power supply circuit is far greater than a frequency audible for human.

### BRIEF DESCRIPTION OF THE DRAWINGS

The accompanying drawings, which are incorporated in and constitute a part of this specification, illustrate embodiments consistent with the disclosure and, together with the description, serve to explain the principles of the disclosure.
Fig. 1 is a circuit diagram of a power supply circuit according to an exemplary embodiment.
Fig. 2 is a circuit diagram of another power supply circuit according to another exemplary embodiment.
Fig. 3 is a circuit diagram of an electronic equipment according to an exemplary embodiment.
Fig. 4 is a block diagram of another electronic equipment according to another exemplary embodiment.

Specific embodiments of the present disclosure are shown by the above drawings, and more detailed description will be made hereinafter. These drawings and text description are not for limiting the scope of conceiving the present disclosure in any way, but for illustrating the concept of the present disclosure for those skilled in the art by referring to specific embodiments.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the disclosure. Instead, they are merely examples of apparatuses and methods consistent with aspects related to the disclosure as recited in the appended claims.

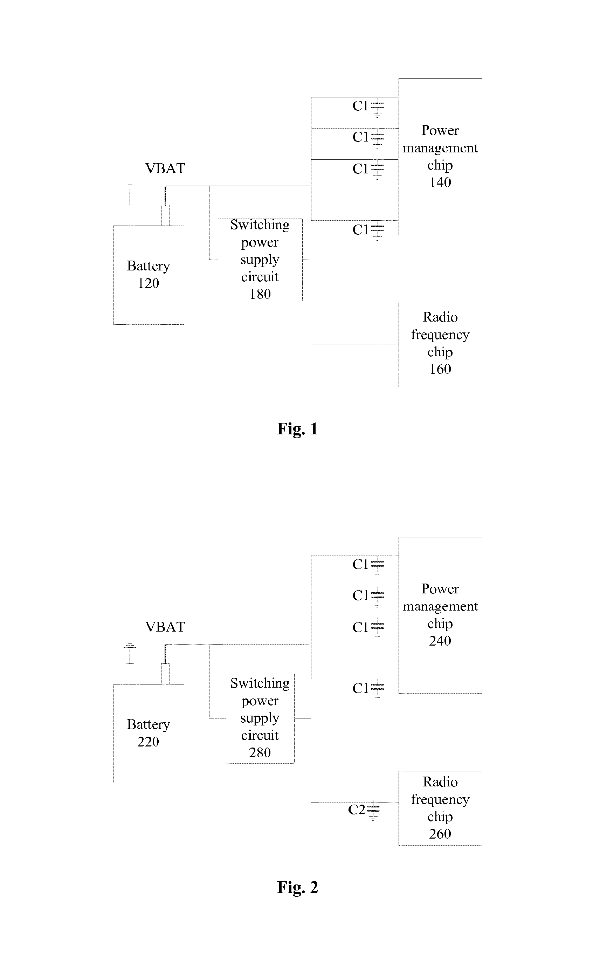

Fig. 1 is a circuit diagram of a power supply circuit according to an exemplary embodiment. The power supply circuit may be applied to the electronic equipment. The power supply circuit 100 includes: a battery 120, a power management chip 140 and an RF chip 160.

An output terminal VBAT of the battery 120 is connected to at least one input terminal of the power management chip 140, while the at least one input terminal of the power management chip 140 is individually grounded via a filter capacitor C1 corresponding thereto, respectively.

The output terminal VBAT of the battery 120 is further connected to an input terminal of the RF chip 160 via a switching power supply circuit 180.

In conclusion, as to the power supply circuit provided by the present embodiment, a switching power supply circuit is provided between the output terminal of the battery and the input terminal of the RF chip, thus solving the problem that a ceramic capacitor may vibrate and give out audible noise when the RF chip sends out signal at a frequency of 216.8HZ required for the communication network, and reaching the effect that the noise produced by the ceramic capacitor, which may still generate vibration although, during its vibration is inaudible for human as the switching frequency of the switching power supply circuit is far greater than a frequency audible for human.

Fig. 2 is a circuit diagram of another power supply circuit according to another exemplary embodiment. The power supply circuit may be applied to an electronic equipment. The power supply circuit 200 includes: a battery 220, a power management chip 240 and an RF chip 260.

An output terminal VBAT of the battery 220 is connected to at least one input terminal of the power management chip 240, and the at least one input terminal of the power management chip 240 is individually grounded via a corresponding filter capacitor C1, respectively. The filter capacitor C1 may be a ceramic capacitor, that is, a capacitor with a package type of MLCC (Multi Layer Ceramic Capacitors).

The output terminal VBAT of the battery 220 is further connected to an input terminal of the RF chip 260 via a switching power supply circuit 280. The input terminal of the RF chip 260 is grounded via an RF filter capacitor C2.

Wherein, the switching power supply circuit 280 may be a DC (Direct Current) BOOST switching power supply circuit, or the switching power supply circuit may be a DC BUCK switching power supply circuit.

A switching frequency of the switching power supply circuit 280, generally of an MHz level, is far greater than a limiting frequency of human audible sound. When the RF chip 260 sends out signal at a frequency required for the communication network, under the influence from the switching frequency of the switching power supply circuit 280, the voltage at the output terminal VBAT of the battery 220 fluctuates at a frequency of an MHz level. Correspondingly, under the influence from the fluctuation of the voltage at the output terminal VBAT of the battery 220, the filter capacitor C1 corresponding to the power management chip 240 may produce noise at an MHz level, which is inaudible for human.

In addition, when the RF chip 260 sends out signal at a frequency required for the communication network, such as GSM network, under the influence from the RF chip 260, the output voltage at the output terminal of the switching power supply circuit 280 may produce fluctuation at a frequency of 216.8HZ. Correspondingly, if the RF filter capacitor C2 is a ceramic capacitor, under the influence from the fluctuation of the output voltage, the RF filter capacitor C2 may still give out audible noise. A tantalum capacitor may be used as the RF filter capacitor C2 in order to eliminate the noise. Such a tantalum capacitor does not produce noise because it has no piezoelectric effect, but its cost is higher than the ceramic capacitor.

In conclusion, as to the power supply circuit provided by the present embodiment, a switching power supply circuit is provided between the output terminal of the battery and the input terminal of the RF chip, thus solving the problem that a ceramic capacitor may vibrate and give out audible noise when the RF chip sends out signal at a frequency of 216.8HZ required for the communication network, and reaching the effect that the noise produced by the ceramic capacitor, which may still generate vibration although, during its vibration is inaudible for human as the switching frequency of the switching power supply circuit is far greater than a frequency audible for human.

In the power supply circuit provided in the present embodiment, a tantalum capacitor is used as the RF filter capacitor C2 at the side of the RF chip 260, thus thoroughly eliminating noise audible for human without too much additional cost.

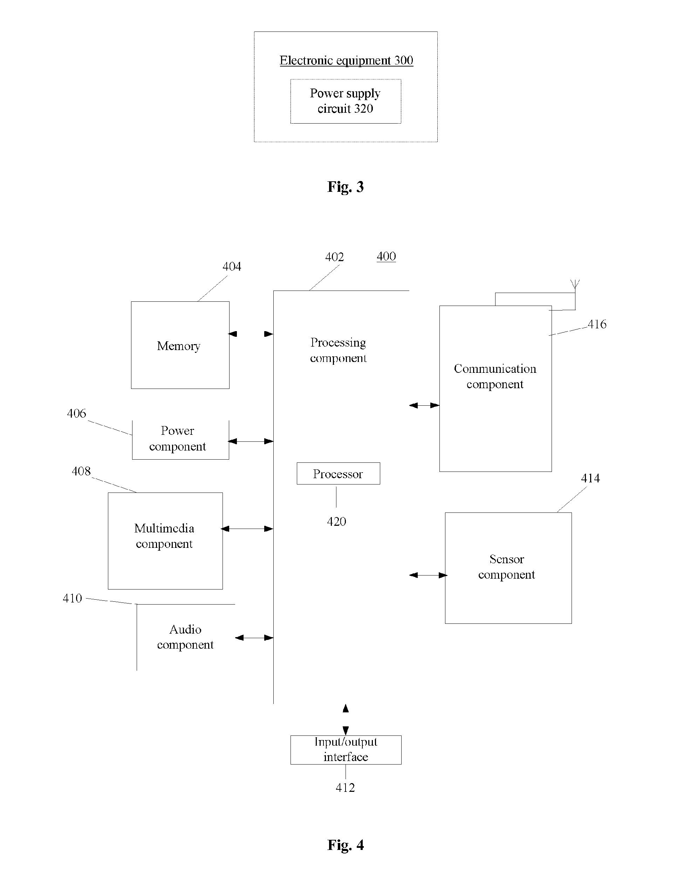

Fig. 3 is a block diagram of an electronic equipment according to another exemplary embodiment. The electronic equipment 300 comprises a power supply circuit 320 as shown in Fig. 1 or 2.

Fig. 4 is a block diagram of an electronic equipment 400 according to an exemplary embodiment. For example, the electronic equipment 400 may be a mobile phone, a computer, a digital broadcast terminal, a messaging device, a gaming console, a tablet, a medical device, exercise equipment, a personal digital assistant, and the like.

Referring to Fig. 4, the electronic equipment 400 may include one or more of the following components: a processing component 402, a memory 404, a power component 406, a multimedia component 408, an audio component 410, an input/output (I/O) interface 412, a sensor component 414, and a communication component 416.

The processing component 402 typically controls overall operations of the electronic equipment 400, such as the operations associated with display, telephone calls, data communications, camera operations, and recording operations. The processing component 402 may include one or more processors 420 to execute instructions to perform all or part of the steps in the above described methods. Moreover, the processing component 402 may include one or more modules which facilitate the interaction between the processing component 402 and other components. For instance, the processing component 402 may include a multimedia module to facilitate the interaction between the multimedia component 408 and the processing component 402.

The memory 404 is configured to store various types of data to support the operation of the electronic equipment 400. Examples of such data include instructions for any applications or methods operated on the electronic equipment 400, contact data, phonebook data, messages, pictures, video, etc. The memory 404 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 406 provides power to various components of the electronic equipment 400. The power component 406 may include a power supply circuit as provided in Fig. 1 or 2.

The multimedia component 408 includes a screen providing an output interface between the electronic equipment 400 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 408 includes a front camera and/or a rear camera. The front camera and the rear camera may receive an external multimedia datum while the electronic equipment 400 is in an operation mode, such as a photographing mode or a video mode. Each of the front camera and the rear camera may be a fixed optical lens system or have focus and optical zoom capability.

The audio component 410 is configured to output and/or input audio signals. For example, the audio component 410 includes a microphone ("MIC") configured to receive an external audio signal when the electronic equipment 400 is in an operation mode, such as a call mode, a recording mode, and a voice recognition mode. The received audio signal may be further stored in the memory 404 or transmitted via the communication component 416. In some embodiments, the audio component 410 further includes a speaker to output audio signals.

The I/O interface 412 provides an interface between the processing component 402 and peripheral interface modules, such as a keyboard, a click wheel, buttons, and the like. The buttons may include, but are not limited to, a home button, a volume button, a starting button, and a locking button.

The sensor component 414 includes one or more sensors to provide status assessments of various aspects of the electronic equipment 400. For instance, the sensor component 414 may detect an open/closed status of the electronic equipment 400, relative positioning of components, e.g., the display and the keypad, of the electronic equipment 400, a change in position of the electronic equipment 400 or a component of the electronic equipment 400, a presence or absence of user contact with the electronic equipment 400, an orientation or an acceleration/deceleration of the electronic equipment 400, and a change in temperature of the electronic equipment 400. The sensor component 414 may include a proximity sensor configured to detect the presence of nearby objects without any physical contact. The sensor component 414 may also include a light sensor, such as a CMOS or CCD image sensor, for use in imaging applications. In some embodiments, the sensor component 414 may also include an accelerometer sensor, a gyroscope sensor, a magnetic sensor, a pressure sensor, or a temperature sensor.

The communication component 416 is configured to facilitate communication, wired or wirelessly, between the electronic equipment 400 and other devices. The electronic equipment 400 can access a wireless network based on a communication standard, such as WiFi, 2G, or 3G, or a combination thereof. In one exemplary embodiment, the communication component 416 receives a broadcast signal or broadcast associated information from an external broadcast management system via a broadcast channel. In one exemplary embodiment, the communication component 416 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the electronic equipment 400 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the above described methods.

In exemplary embodiments, there is also provided a non-transitory computer-readable storage medium including instructions, such as included in the memory 404, executable by the processor 420 in the electronic equipment 400, for performing the above-described methods. For example, the non-transitory computer-readable storage medium may be a ROM, a RAM, a CD-ROM, a magnetic tape, a floppy disc, an optical data storage device, and the like.

## Claims

1. A power supply circuit, **characterized in** comprising: a battery (120, 220), a power management chip (140, 240) and a radio frequency chip (160, 260);
an output terminal of the battery is connected to at least one input terminal of the power management chip, while the at least one input terminal is individually grounded via a corresponding filter capacitor (C1); and
the output terminal of the battery is further connected to an input terminal of the radio frequency chip via a switching power supply circuit (180, 280).

2. The power supply circuit of claim 1, wherein a switching frequency of the switching power supply circuit (180, 280) is greater than a limiting frequency of human audible sound.

3. The power supply circuit of claim 1, wherein the switching power supply circuit (180, 280) is a DC BOOST switching power supply circuit.

4. The power supply circuit of claim 1, wherein the switching power supply circuit (180, 280) is a DC BUCK switching power supply circuit.

5. The power supply circuit according to any of claims 1-4, wherein the input terminal of the RF chip is grounded via a radio frequency filter capacitor (C2).

6. The power supply circuit of claim 5, wherein the radio frequency filter capacitor (C2) is a tantalum capacitor.

7. The power supply circuit according to any of claims 1-4, wherein the filter capacitor (C1) is a ceramic capacitor.

8. An electronic equipment, **characterized in** comprising a power supply circuit according to any one of claims 1-7.
